# EUROPEAN PATENT APPLICATION

(11) **EP 4 641 632 A1**
(43) Date of publication of application: **29.10.2025**
(21) Application number: 24172064.8
(22) Date of filing: 24.04.2024
(51) Int. Cl.: H01L 23/495, H01L 23/31

(54) **A SEMICONDUCTOR PACKAGE AND A METHOD OF MANUFACTURING THE SEMICONDUCTOR PACKAGE**

(71) Applicant: Nexperia B.V., 6534 AB Nijmegen (NL)
(72) Inventor: Yandoc, Ricardo, Manchester, SK7 5BJ (GB); Taduran, Arnel, Manchester (GB)
(74) Representative: Pjanovic, Ilija

(57) **Abstract**

A semiconductor package is proposed comprising an electrically conductive lead frame having at least two strip-like lead terminals; at least one semiconductor die structure mounted to the lead frame; and one or more connection elements electrically connecting the at least one semiconductor die structure with the at least two strip-like lead terminals; a molding resin encapsulating the lead frame, the at least one semiconductor die structure and the one or more connection elements, such that an elongated portion of each of the at least two lead strip-like terminals are exposed; wherein the exposed elongated portion of each of the at least two strip-like lead terminals is formed of a first portion part positioned at the free end of the elongated portion and at least a further portion part extending from the first portion part away from the free end, with the first portion part structured - during use - to be mechanically and electrically connected to a printed circuit board and at least one elongated side edge of the further portion part is provided with at least one notch.

## Description

### TECHNICAL FIELD

The present disclosure relates to a semiconductor package with lead terminals structured for mounting on a printed circuit board through soldering and to a method of manufacturing said semiconductor package.

### BACKGROUND OF THE DISCLOSURE

Semiconductor packages are essential for semiconductor die structures by protecting them from physical damage or dust contamination by means of encapsulation with a molding resin. Additionally, they offer a pathway for heat dissipation through the housing and a way to connect the semiconductor die structures by means of exposed lead terminals to a substrate with electronic circuitry, known as a printed circuit board (PCB), such that the semiconductor die structure can fulfil its function in the overall circuit.

Typically, the semiconductor packages are connected at their lead terminals with solder to the PCB, creating a mechanically fixed and electrically conductive connection. Unfortunately, due to the heating up of the semiconductor die structure and the subsequent thermal expansion of the semiconductor package, a stress is generated on the solder connections, which typically fail and break after continued stress exposure, leading to malfunctioning of the overall electronics.

The heat dissipation of the semiconductor package can never be fully mitigated. Therefore, the exposed ends of the lead terminals have been designed with various shapes to ensure a better mechanical fixation through soldering between the lead terminals/the semiconductor package and the PCB. However, these designs lessen the electrically conductivity between the lead terminal with the PCB, and accordingly adversely affect the electric functionality of the semiconductor package.

Therefore, it is the goal of the present disclosure to provide an improved semiconductor package offering better mechanical connection of the exposed lead terminals to the PCB capable of withstanding prolonged stress exposure without reducing the electrical conductivity.

### SUMMARY OF THE DISCLOSURE

The disclosure describes a semiconductor package that provides an improved lead terminal offering a better mechanical connection to the PCB, whilst ensuring that electrical conductivity remains established even after prolonged stress exposure. To do so the semiconductor package comprises an electrically conductive lead frame having at least two strip-like lead terminals as well as at least one semiconductor die structure mounted to the lead frame. In addition, one or more connection elements are provided electrically connecting the at least one semiconductor die structure with the at least two strip-like lead terminals. Furthermore, it comprises a molding resin encapsulating the lead frame, the at least one semiconductor die structure and the one or more connection elements, such that an elongated portion of each of the at least two lead strip-like terminals are exposed.

The exposed elongated portion of each of the at least two strip-like lead terminals is formed of a first portion part positioned at the free end of the elongated portion and at least a further portion part extending from the first portion part away from the free end, with the first portion part structured - during use - to be mechanically and electrically connected to a printed circuit board and at least one elongated side edge of the further portion part is provided with at least one notch.

The semiconductor package according to this disclosure has the advantage that it offers improved mechanical fixation with the PCB substrate, while not limiting electrical conductivity. Known lead terminals try to offer an improved mechanical fixation by providing recesses or notches in the lead terminal at the first portion part, where the lead terminal is connected to PCB substrate. This solution only offers stability in the plane of the PCB, whereas stress operates in three dimensions. Therefore, such mechanical connections according to these solutions typically break along the surface of the PBC, providing no longer any electrical connectivity. Moreover, providing a recess in the first portion part, where the lead terminal is connected to the PCB, also reduces the electric conductivity of the lead terminal at the location where high electric conductivity is desired.

By providing at least one notch along at least one of the elongated side edges of the exposed lead terminal at or in the further portion part, adjacent to the first portion part away from the free end of the lead terminal, the conductivity at the desired location is not reduced, while still improving the stability of the connection. Another additional advantage of having at least one notch at the at least one elongated side edge in the further portion part of the exposed lead terminal allows to check whether the welding or the soldering to the PCB substrate has been done correctly or not. It should be noted, that visually checking the quality of the solder weld in between the PCB and a closed lead terminal is not possible, whereas having a notch at least one of the elongated side edges thereof adjacent to the first portion allows for proper visual inspection. In that case, when soldering is done correctly some solder will flow properly and creep up into the notch. The presence of solder in the notch can be used as an indication that the welding has been performed properly, since the solder has melted enough to flow and to fill all areas between the PCB and the further portion of the exposed lead terminal not directly connecting the PCB.

To improve the stability of the mechanically connection between the further portion of the exposed lead terminal and the PCB even further, another example of the semiconductor package according to the disclosure is proposed, wherein the at least one notch is provided near a transition area between the first portion part and the further portion part.

The transition area between the first portion part and the further portion part is often shaped as an arched portion of the lead terminal, when the latter is mounted to a PCB. Likewise, the solder connecting the lead terminal to the PCB will also have to bend and arch. Upon welding, the molten solder will flow and creep up this arch and into the at least one notch providing a proper mechanical connection. This ensures that not one single direction becomes weaker than another, and accordingly any excess material stresses in the material of the exposed lead terminal caused by thermal expansion can be avoided. Herewith stability of the mechanical connection is achieved in three dimensions. In other words, the solder is used as an anchor for the exposed lead terminal, which does not exhibit one weak direction.

In another example of the semiconductor package, a cross-section of the at least one notch has a shape selected from but not limited to a semicircle, semi-ellipse, rectangle, square, semi-hexagonal, or triangle.

Dependent on the type of application, having a different shape of the notch allows for mitigating forces in several preferred directions. For instance, a semicircle mitigates forces in all directions, except outwardly of the notch. In those cases, another preferred shape may be chosen, much like a triangle with its wide base closer to the center of the lead terminal.

In a preferred example of the semiconductor package, a width dimension of the at least one notch is larger than a thickness dimension of the lead terminal.

In another preferred example the width dimension of the at least one notch is smaller than 50% of the width distance between the elongated side edge to the other, opposite elongated side edge of the lead terminal.

The inventors have found out through simulations of thermal stress and through stress tests that the dimensions of the notch have lower and upper bounds. Whenever the width of the at least one notch was larger than 50% of the width of the lead terminal, seen in the direction from the elongated side edge to the other, opposite elongated side edge, the lead terminal would become too fragile in mechanical terms, and could also no longer provide efficient electric conductivity.

Furthermore, the inventors found that notches provided at the elongated side edge(s) of the exposed lead terminal which are too small would no longer provided a proper filling reservoir for solder because of an absence of capillary action and insufficient solder flow.

In yet another example of the semiconductor package, the at least one notch comprises a plurality of notches.

Having a plurality of notches, especially but not necessarily positioned on opposite elongated side edges of the lead terminal, meaning for instance one notch on an elongated side edge and the other notch on another elongated side edge, aids in the stability of the mechanical connection of the lead terminal to the PCB. Namely, multiple notches can offer stability in different direction either due to their position or due to their shape. The combination of multiple notches offers improved mechanical stability as a whole.

Worth noting is that the lower and upper bounds for the width of the notch have been found to be also translate to cases wherein the at least one lead terminal comprises a plurality of notches. In other words in these cases the widths of the notches should be considered in summation of each other, especially when they are aligned in a direction perpendicular to the elongated side edge of the lead terminal. For instance, when having two notches of equal dimensions, each notch depth must be smaller than 25% of the width of the lead terminal. Otherwise a center portion of the lead terminal would remain having an insufficient width dimension, sic. insufficient lead terminal material for providing a proper mechanical and electrical connection.

Another preferred example of the semiconductor package is typified by providing the plurality of notches on both elongated sides of each of the at least two lead terminals.

Similarly to the reasoning above, oppositely placed notched on the lead terminal offer mechanical stability to oppositely posed stress forced. Therefore, all complete three dimensions can be covered, and mechanical stability is ensured.

In yet another example the further portion part of the exposed lead terminal of the semiconductor package may be further provided with at least one through bore extending through the lead terminal.

Much similarly to the notches, a recess can also provide additional stability. Especially the combination of a notch and a recess allow to provide a proper mechanical connection, which maintaining a proper electrical connection.

The disclosure further pertains to a method of manufacturing the semiconductor package. The method comprises the method comprising the steps of:
i) preparing an electrically conductive lead frame comprising at least two lead terminals;
ii) providing at least one notch in at least one of the elongated sides of each of the lead terminals;
iii) mounting at least one semiconductor die structure on the lead frame;
iv) electrically connecting, using one or more connection elements, the at least one semiconductor die structure with the at least two lead terminals;
v) encapsulating, using a molding resin, the lead frame, the at least one semiconductor structure, and the one or more connection elements into a package exposing elongated portions of the at least two lead terminals; and
vi) trimming residual material from the elongated portions of the lead terminals, thereby forming a first portion part positioned on the free end of the elongated portion, structured to be mechanically and electrically connected to a printed circuit board during use and a further portion part provided with the at least one notch.

By following these steps an effective and efficient process can be established to manufacture a semiconductor package having at least one notch in at least one elongated side edge of each of the at least two lead terminals thus ensuring improved mechanical connectivity between the semiconductor package and the PCB.

In an example of the method according to the disclosure, step iii) is performed prior to step ii),

In a preferred example the step i) of preparing the electrically conductive lead frame is performed by stamping, cutting or chemical etching.

In another preferred example the step ii) of providing the at least one notch is performed by stamping, cutting, chemical etching or milling.

The thickness of the lead frame can vary from application to application and therefore various methods might be more suitable in creating the correct pattern with the correct resolution. Moreover, a lot of waste material is generated which needs to be effectively removed and recycled which can be done through chemical means.

### BRIEF DESCRIPTION OF THE DRAWINGS

The disclosure will now be discussed with reference to the drawings, which show in:
Figure 1A-1B a prior art semiconductor package and solder formation;
Figure 2 a semiconductor package according to a first example of the disclosure;
Figures 3A-3B solder formation around the lead terminal in more detail;
Figures 4A-4B the semiconductor package of Figure 2 with solder formation;
Figures 5A-5B-5C further examples of lead terminals according to the disclosure;
Figures 6A-6B further details of the lead terminals according to the disclosure;
Figures 7A-7B two further examples of the lead terminals according to the disclosure;
Figure 8 a method of manufacturing a semiconductor package according to the disclosure.

### DETAILED DESCRIPTION OF THE DISCLOSURE

For a proper understanding of the disclosure, in the detailed description below corresponding elements or parts of the disclosure will be denoted with identical reference numerals in the drawings.

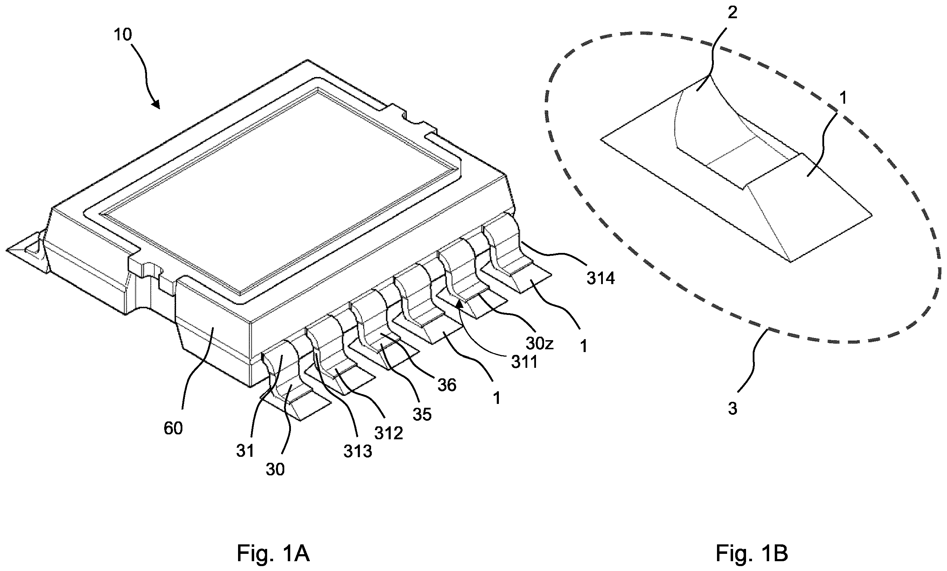

Figures 1A and 1B depict a semiconductor package 10 and solder formation 1, respectively, of a known semiconductor packages 10. Because of stress induced by thermal effects, a lot of mechanical stress of force is exerted on the connection points of the semiconductor package 10 with the printed circuit board (PCB) substrate 3. Typically these connections are made through lead terminals 30 extending out of the resin molded body 60 of the semiconductor package 10. The free ends 30z of the exposed portions of these lead terminals 30 are then connected with solder 1 forming a mechanical and electrical connection between the semiconductor package 10 and the PCB 3 by means of a solder protrusion 2.

Typically these lead terminals 30 comprise elongated portion 31, which has a width larger than its thickness and a length longer than both of these dimensions. Semiconductor package implementing such strip-like terminals are known as so-called gullwing packages. Part of the exposed elongated portion of the lead terminal is connected to the PCB 3 with its second surface 312, keeping the first surface 311 exposed. More specifically, the exposed portion of the lead terminal is bend, arched, or curved in such a way that a first portion part 35 at the free end 30z of the lead terminal extends approximately parallel to the PCB 3 and such that a further portion part 36 extending from the first portion part 36 away from the free end 30z and adjacent to the first portion part 35, curves away from the PCB surface 3. The long thin elongated sides of the lead terminal 30 can be described as an elongated side 313 and another elongated side 314, being opposite to the elongated side 313.

Because the mechanical solder connection between the lead terminal 30 and the PCB 3 mainly comprises the interface between the first surface 311 and the solder 1, all stress-induced forces act on this connection. Moreover, since this connection is mostly two dimensional the mechanical forces exerted due to thermal expansion act along the plane of the PCB. Therefore, breakage of the mechanical connection and subsequent malfunctioning of the prior art semiconductor package 10 are likely to occur.

Other known designs have tried to mitigate these effects to reduce breakage of the connection by providing a recess in the first portion part 35 at the free end 30z of the lead terminal 30 to allow solder 1 to fill the recess, creating somewhat of an anchor point for the lead terminal 30. However, the inventors have found that this approach only offers mechanical stability in two dimensions,. along the two-dimensional plane of the PCB 3. Moreover, having a recess at the free end 30z35 of the lead terminal 30 forming the mechanical connection with the PCB 3, significantly reduces the electrically conductive properties of the lead terminal 30 with the PCB 3. This may especially be an issue with semiconductor packages, which need to transfer a lot of energy, for example power packages.

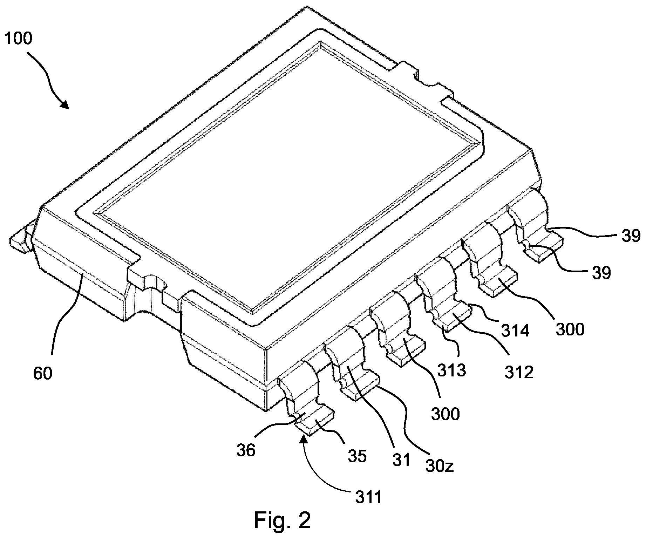

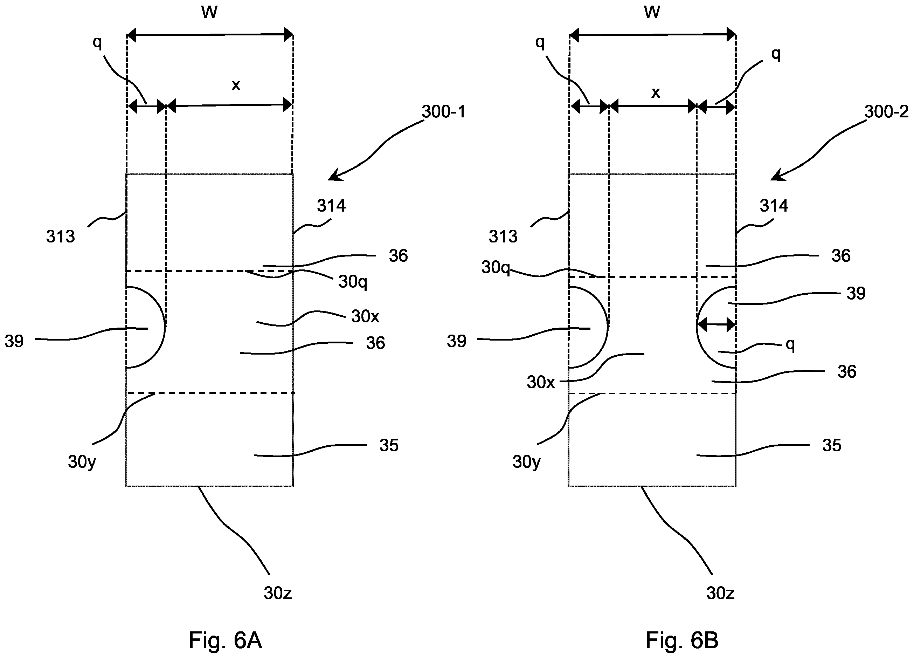

Therefore it is the goal of the disclosure to propose a semiconductor package with an improved design of lead terminal thereby offering a better mechanical connection to the PCB 3, whilst ensuring that electrical conductivity between the semiconductor package and the PCB remains established even after prolonged stress exposure. To do so, Figure 2 depicts a first example of a semiconductor package 100 according to the disclosure (see also Figure 6). The semiconductor package 100 comprises an electrically conductive lead frame 20 having multiple lead terminals 300, at least one semiconductor die structure 40 mounted to the lead frame 20, and one or more connection elements 50 electrically connecting the at least one semiconductor die structure 40 with the multiple lead terminals 30.

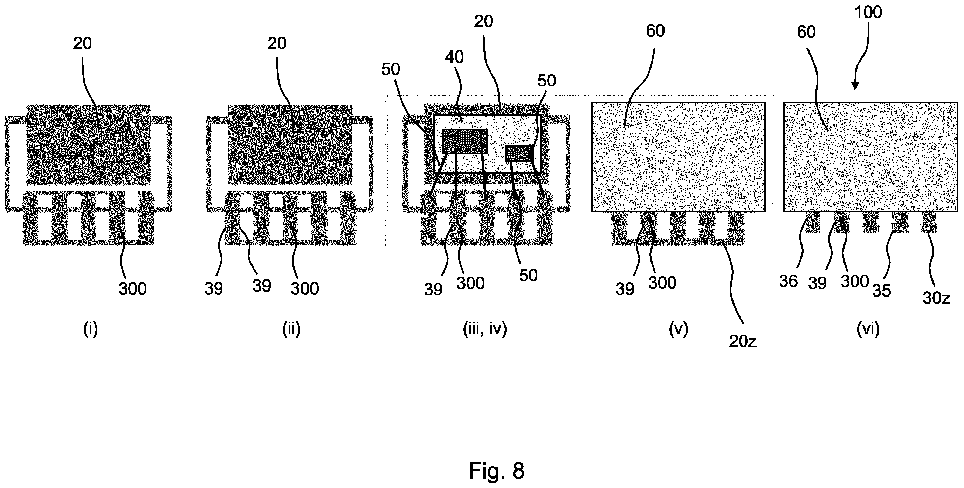

Furthermore (see Figure 8), the semiconductor package 100 according to the disclosure comprises a molding resin 60 encapsulating the lead frame 20, the at least one semiconductor die structure 40 and the one or more connection elements 50, such that an elongated portion 31 of the at least two terminals 300 are exposed. According to the disclosure, the semiconductor package 100 implements a new design of lead terminals 300, which comprises at least one notch 39 provided in each of the elongated portions 31 of each of the at least two lead terminals 300. The exposed elongated portion 31 of each of the at least two lead terminals 300 has a first surface 311 and a second surface 312 opposite of the first surface 311. The exposed elongated portion 31 furthermore comprises a first portion part 35 positioned on the free end 30z of the elongated portion 31, which first portion part 35 is structured to be mechanically and electrically connected with its first surface 311 to a surface 3a of a printed circuit board 3 during use. A further portion part 36 extending from the first portion part 35 away from the free end 30z of each lead terminal 300 is provided with the at least one notch 39 positioned on an elongated side 313/314, which elongated sides 313/314 are being perpendicular to both the first 311 and the second surface 312.

A first example of such semiconductor package 100 according to the disclosure is depicted in Figure 2. Here, a semiconductor package 100 is shown with twelve exposed elongated portions 31 of twelve lead terminals 300 protruding out of the resin molded body 60 of the semiconductor package 100. It is to be understood that this number of lead terminals 300 is arbitrary and depends on the application of the semiconductor package 10. Figure 2 further shows that every lead terminal 300 is intended to be connected to a PCB 3 at its first portion part 35 at the free end 30z of each lead terminal 30. In practice or during use, this first portion part 35 at the free end 30z of the exposed lead terminal 300 is bend relative to the further portion part 31, such that the first portion part 35 is oriented approximately parallel to the plane of the PCB surface 3.

The particular configuration of the lead terminal 300 may also be known as a gullwing shape, and the lead terminal 300 may function as a leg of the semiconductor package 100. This leg can be subdivided into the feet, being the first portion part 35 with which the lead terminal 300 is mechanically and electrically connected to the PCB 3, and the ankle, being part of the further portion part 36, being more specifically the transition area 30x. The gullwing lead terminal 300 of Figure 2 is defined by the at least one notch 39 being located on its ankle. This allows for a better and more stable connection, while not reducing the conductivity in the feet of the lead terminal 300.

To improve the stability of the mechanical connection, in the example of Figure 2, the further portion part 36 of each exposed elongated portion 31 extending from the first portion part 35 away from the free end 30z of each lead terminal 300 is provided with two notches 39, each notch 39 being provided in an elongated side edge 313 and 314 of the. The notches 39 will ensure a proper mechanical connection with (the surface 3a of) the PCB 3 through soldering, whereas the electrical conductivity is not lost in the first portion part 35, which is forming the electrical connection with the PCB 3, and thus mechanical stability is achieved.

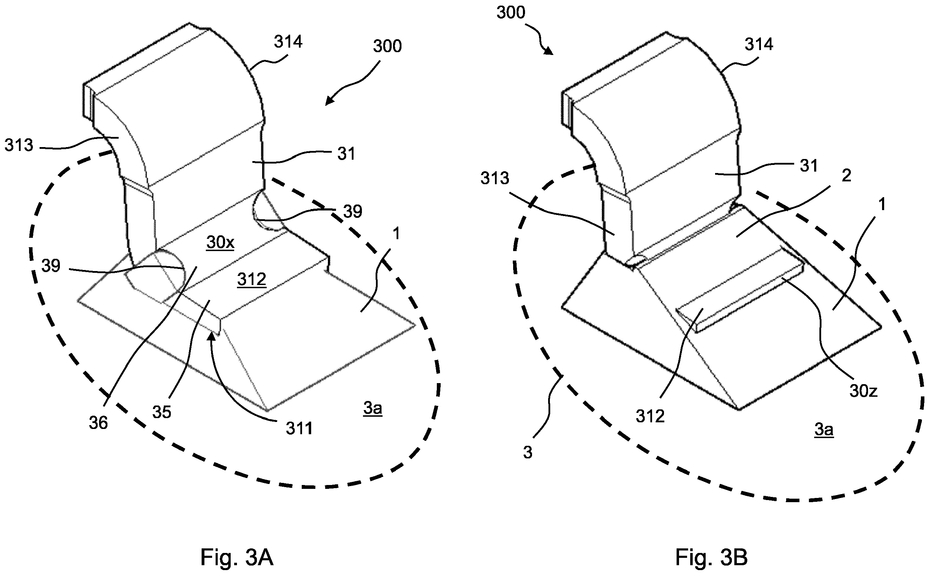

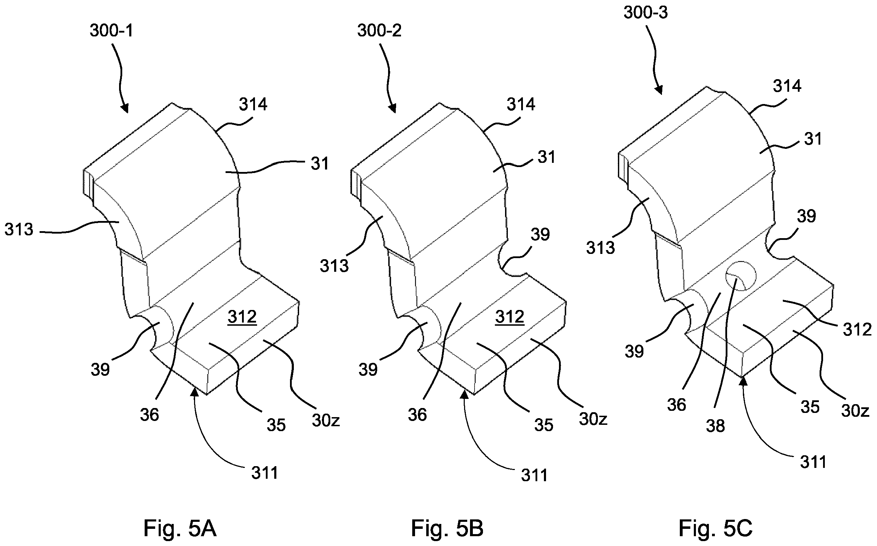

During mounting of the semiconductor package 100 according to the disclosure, the solder 1 will be melted and flows up along the arch of the lead terminal 300, due to capillary action, flowing into the two notches 39 and locally around the elongated side edges 313/314 and subsequently solidifies. Each notch 39 will then provide mechanical stability for a roughly half of the three dimensional space and since they are positioned opposite this covered space will be opposite as well. Thus by providing two notches 39 provided at opposite elongated side edges 313/314 of the exposed elongated portion of the lead terminal 300, a three dimensional space (X, Y ,and Z) is covered and mechanically stabilized. The soldering of the lead terminal 300 with two notches 39 is shown in more detail in more detail in Figures 3A-3B and Figure 5B.

Moreover, since the notches 39 are provided in an arched portion 36 of the lead terminal 30, stability is provided not just parallel to the PCB 3. Any stress-induced forces and their anchor points are shifted in relation to each other, thus offering more stability, contrary to the known designs, which provide stability in only provided along the plane of the PCB 3 (in only X and Y direction).

The design of the lead terminal 300 according to the disclosure as shown in Figure 2 is understood in the industry as a seagull wing shape. The disclosure is not limited to such a design shape of the lead terminal 300, however it is important for the disclosure that the at least one notch 39 is provided in a curved portion 36 being adjacent to the first portion part 35 near or at the free end 30z of the lead terminal 300.

Worth noting is that a lot of stability can be achieved by having two notches 39 positioned oppositely to each other at each elongated side edge 313 and 314 as show in Figure 2 and in more detail in Figures 3A-3B and Figure 5B. However this choice of design depends on the application of the semiconductor package 10. For example, in some cases it can suffice and each lead terminal 30 is provided with only one notch 39, but that neighboring lead terminals 30 have the notches 39 provided oppositely to each other. This way more electrical conductivity can be achieved while still maintaining the stability in all three dimensions.

Another additional advantage over existing "stability-improving" designs by having at least one notch 39 in the further portion part 36 of the lead terminal 300 allows the user to check whether welding to the PCB substrate 3 has been done correctly or not. By checking the quality of the solder weld 1 in between the PBC 3 and a closed lead terminal 30 according to the prior art and as depicted in Figure 1A is impossible visually. With the improved design of the lead terminal 300 according to the disclosure implementing at least one notch 39 visual inspection becomes possible, since when soldering is done correctly some solder 1 will creep up into said notch 39 and around the elongated side edge 313 (and/or 314) forming a solder protrusion 2. The presence of solder by means to the solder protrusion 2 in the notch 39 can be used as an indication that the welding has been performed properly. The reasoning behind this is when solder 1 is present in the notch 39, the solder 1 has to be melted enough to fill all areas in between the PCB 3 and the lead terminal 30 and to creep up as a solder protrusion 2 into said notch 39 and around the elongated side edge 313-314.

This solder formation 1 is shown in Figures 3A and 3B, showing two potential formations of the solder 1 upon welding. In these Figures a zoom-in is shown of the elongated portion 31 of the lead terminal 300, showing a so-called gullwing lead terminal formed as a long and thin or strip-like lead terminal 300 having a longitudinal dimension being greater than a width dimension, which width dimension is furthermore greater than a thickness dimension of the strip-like lead terminal 300. Accordingly, the exposed elongated portion of such strip-like lead terminal 300 is characterized by the first surface 311, the second surface 312 opposite to the first surface 311, the first elongated side edge 313, and another, second elongated side edge 314 opposite to the first elongated side edge 313. The lead terminal 300 is mounted to a surface 3a of a PCB 3 with its first surface 311 and two notches 39 are provided opposite to each other at each elongated side edge 313 and the other elongated side edge 314, respectively. Furthermore, the notches 39 are positioned at the respective elongated side edges 313 and 314 of the further portion part 36, extending from the first portion part 35 away from the free end of each lead terminal 300, with which first portion 35 the lead terminal 300 is mechanically and electrically connected to the surface 3a of the PCB substrate 3.

As shown in Figure 3A, the solder 1 forms two anchoring points on either side of the lead terminal 300. These anchoring points offer the stability in three dimensions as discussed above, but also provide visual indication of whether the soldering weld was made correctly.

In Figure 3B another solder formation 1 is shown with the same lead terminal 300 as used in Figure 3A. This time more solder material has been used causing the solder 1 to overflow and also cover part of the second surface 312 by almost fully covering the first portion part 35 and part of the further portion part 36 and around both elongated side edges 313 and 314. As a result, the notches 39 are therefore almost no longer visible, but this visibility check (of Figure 3B) ensures that solder formation thus achieved provides mechanical stability in three dimensions or three directions (X, Y and Z).

In other words, the presence of the at least one notch 39 in the transition area 30x, or also known as the ankle of the lead terminal 300, provides a visual indicator for solder 1 spread. The notch 39 could either be empty, indicating that the solder 1 has not melted or too little solder 1 was provided, resulting in a bad and/or weak mechanical and electrical connection of the lead terminal 300 to the PCB 3. Alternatively, the notch 39 could be filled with solder 1, indicating that the solder 1 has melted correctly and a stable mechanical and electrical connection is achieved between the lead terminal 300 and the PCB 3.

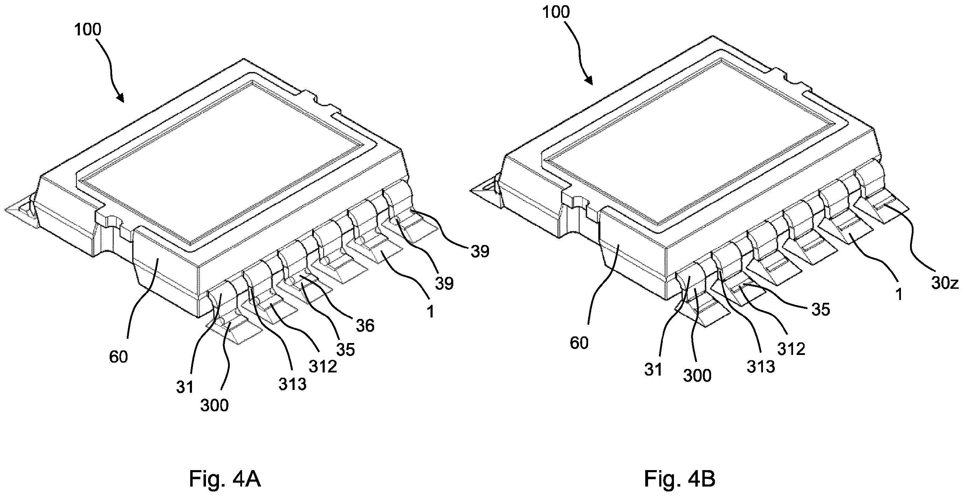

Full overview figures of the complete semiconductor package 100 according to the disclosure are shown in Figures 4A and 4B, showing the same solder formations as in Figures 3A and 3B, respectively.

Here, one can clearly see that the lead terminal 300 can be viewed as being the legs of the semiconductor package 100. Herein the feet is considered being represented by the first portion part 35 at the free end 30z of the lead terminal 300, which form the parts of the lead terminal 300 that are mechanically and electrically connected to the PCB 3. Right above the feet, the ankle, known as the transition area 30x, is located comprising the at least one notch 39. The presence of this notch in the ankle allows for connecting the semiconductor package 1 to the PCB in a stable manner without reducing the conductivity in the first portion part 35, or the feet.

Figures 5A-5B-5C show three designs of lead terminals according to the disclosure, denoted with reference numerals 300-1, 300-2 and 300-3. In Figure 5A lead terminal 300-1 is provided with only one notch 39 in the elongated side edge 313 at the arched further portion part 36 extending from the first portion part 36 away from the free end 30z of the lead terminal 300-1. This design of Figure 5A ensures through the lead terminal 30, while still offering 3 dimensional stability. This design can especially be effective when a neighboring lead terminal 300 has its notch 39 provided in the opposing another elongated side edge 314.

This effect can also be achieved in a single lead terminal 300-2 as is shown in Figure 5B, which design is identical to the example of Figure 2 and Figures 3A-3B. Here, the opposing notches 39 are provided in the elongated side edge 313 and the other opposite elongated side edge 314 at the arched or bend further portion part 36. This design offers more stability for a single lead terminal 30, but would still allow enough current to flow through the material of the further portion part 36 of the lead terminal 300-2.

In the design of Figure 5C, the elongated portion 31 of the lead terminal 300-3 is provided with an additional recess or through bore 38 in the arched further portion part 36 between both notches 39 which are provided in the respective elongated side edges 313 and 314. This design offers the greatest mechanical stability against thermal stress for the lead terminal 300-3, due to the improved anchoring through the solder 1, however care should be taken that electrical conductivity is also slightly reduced this way as less material is present in the further portion 36 of the lead terminal 300-3 to allow current to flow through.

The examples shown in Figures 5A-5B-5C, all depict circular notches 39 and circular recesses/through bores 38. The disclosure is however not limited to only circular shapes. A cross-section of the at least one notch 39 or the at least one recess/through bore 38 seen along the width dimension W of the strip-like lead terminal 300 in the direction of the first elongated side edge 313 towards the other elongated side edge 314 may have a shape selected from but not limited to a semicircle, semi-ellipse, rectangle, square, semi-hexagonal, or triangle.

The shape of the notch 39 or the recess 38 allows for mitigating forces in several preferred directions. For instance, a semicircle mitigates forces in all directions, except in an outward direction of the notch. In those cases, another preferred shape may be chosen.

The examples of Figures 5A-5B-5C do not show it, but multiple notches 39 can also be provided next to each other along the same elongated side edge 313 (and/or 314).

The inventors have found through stress tests that the dimensions of the notch 39 and the recess 38 have lower and upper bounds. With reference to Figure 6A and 6B, it has been discovered that a width dimension q of the at least one notch 39 should be larger than a thickness dimension of the strip-like lead terminal 300, that is larger than the thickness dimension between the first surface 311 and the second surface 312.

In particular, as shown in Figure 6A, the width dimension q of the single notch 39 should be smaller than 50% of the width distance W between the elongated side edge 313 and the other, opposite elongated side edge 314 of the lead terminal 300-1. When the design of the lead terminal 300-2 is implemented, thus having two notches 39 at each elongated side edge 313-314, the combined width dimension of both notches 39 (being 2 x q) should be smaller than 50% of the width distance W between the elongated side edge 313 and the other, opposite elongated side edge 314 of the lead terminal 300-2.

When the remaining width portion x of the strip-like lead terminal 300-1 (or 300-2) of the designs of Figures 6A and 6B would be smaller than 50% of the overall width dimension W, the lead terminal 300-1 (or 300-2) would become too fragile and the reduced amount of lead terminal material could not efficiently conduct electricity anymore. Additionally, the inventors have found that notches 39 that are too small would no longer fill themselves with solder 1 due to a reduced capillary action. A lower width dimension q of each notch 39 should be at least equal to the thickness dimension of the strip-like lead terminal 300. Alternatively, the lower width dimension q of each notch 39 could be 10% of the overall width dimension W of the strip-like lead terminal 300.

The inventors have also found that these lower and upper bounds are true for combination of notches 39 and recesses 38. Therefore, the combined dimensions have to be considered. In other words in these cases the widths of the notches 39 should be considered in summation of each other, especially when they are aligned in a direction perpendicular to the elongated side edges 313/314 of the lead terminal. For instance, when having two notches 39 of equal dimensions, each notch depth must be smaller than 25% of the width of the lead terminal 300, in order to account for the maximum amount of 50%. If this were not the case, no center portion of the lead terminal 10 would remain.

Furthermore, the examples of Figures 6A-6B show a portion parts interface 30y between the first portion part 35 and the further portion part 36, which indicates the transition from the first portion part 35 to the further portion part 36. This portion parts interface 30y may also be known as the heel of the strip-like lead terminal 300 and the notch 39 is preferably located at or close to this interface 30y.

The region of the further portion part 36, wherein the notch is provided may also be known as the transition area 30x, which is adjacent to the first portion part 35 and the portion parts interface 30y. The transition area 30x extends into the further portion part 36, but does not cover it completely. More specifically, it is delineated by the transition area boundary 30q. The transition area 30x may also be known as the ankle of the lead terminal 300 (300-1, 300-2), such that the lead terminal 300 connects to the PCB substrate 3 with the first portion part 35 (or foot) and such that the at least one notch 39 is provided in the ankle of the lead terminal 300.

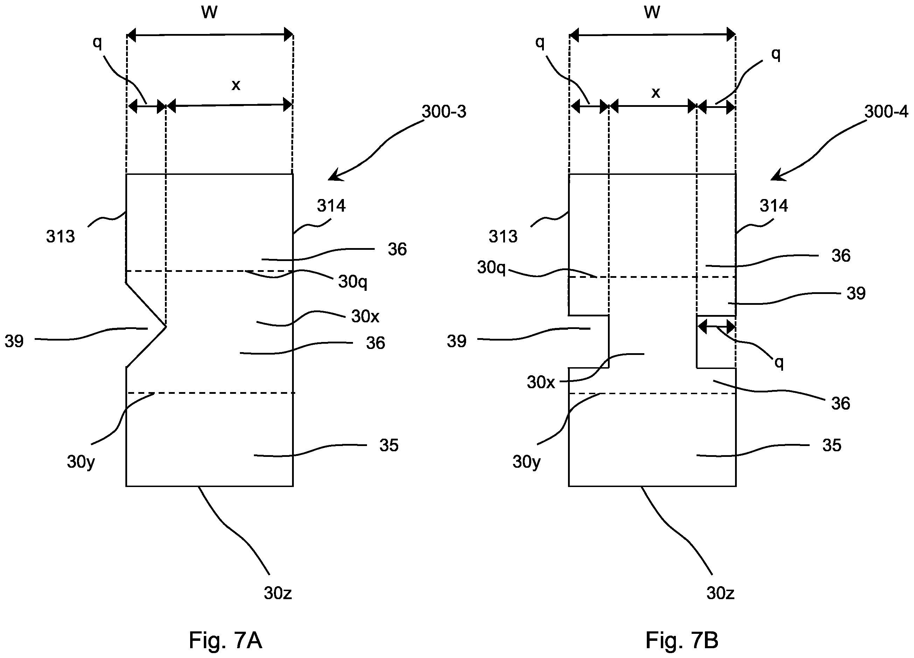

The Figures 7A-7B show similar representations of the lead terminals 300 (denoted 300-3 and 300-4) as in the Figures 6A-6B. However, in Figure 7A the notch 39 is expressed as a triangular shape when seen in the plane of the first surface 311. Dependent on the type of application, having a different shape of the notch 39 allows for mitigating forces in several preferred directions. For instance, the semicircular shape from Figures 6A mitigates forces in all directions, except outwardly of the notch. Whereas, the triangular shape of Figure 7A has two preferred direction for force mitigation, both being at an angle to the longitudinal direction of the lead terminal 300-3.

Another example of a shape of the notch 39 is shown in Figure 7B, wherein the notch has a rectangular shape. With this configuration, the force mitigation is along and perpendicular to the longitudinal direction of the lead terminal 300-4.

In Figure 8 a method of manufacturing the semiconductor package is shown, wherein the following steps are depicted in the various partial drawings (i)-(vi):
i) preparing an electrically conductive lead frame 20 comprising at least two lead terminals 300;
ii) providing at least one notch 39 in at least one of the elongated side edges 313-314 (in one or both elongated side edges) of each of the lead terminals 300;
iii) mounting at least one semiconductor die structure 40 on the lead frame 20;
iv) electrically connecting, using one or more connection elements 50, the at least one semiconductor die structure 40 with the at least two lead terminals 300;
v) encapsulating, using a molding resin 60, the lead frame 20, the at least one semiconductor structure 40, and the one or more connection elements 50 into a package exposing elongated portions 31 of the at least two lead terminals 300; and
vi) trimming residual material 300z from the elongated portions 31 of the lead terminals 300, thereby forming a first portion part 35 positioned on the free end 30z of the elongated portion, structured to be mechanically and electrically connected to a printed circuit board 3 during use and a further portion part 36 provided with the at least one notch 39.

It should be noted that according to the disclosure step iii) can be performed prior to or after step ii).

Herewith it is assured that the notch 39 is not located in a first portion part 35 at the free end 30z of the terminals 300, but at or in a further portion part 36 extending from the first portion part 35 away from the free end 30z thereof. Thereby the electrical conductivity is not limited, which does occur in already known designs that try to create better connections between the semiconductor packages 10 and the PCB 3. In particular, the conductivity at the desired location is not reduced, while still improving the stability of the connection. Another additional advantage of having at least one notch 39 at the at least one elongated side edge in the further portion part of the exposed lead terminal allows to check whether the welding or the soldering to the PCB substrate 3 has been done correctly or not.

For efficiency reasons step i) and or step ii) may be performed by stamping, cutting or chemical etching. The exact preferred method depends on the thickness of the lead frame in turn determined by the application and therefore various methods might be more suitable in creating the correct pattern with the correct resolution.

By following these steps an effective and efficient process can be established to manufacture a semiconductor package 10 having at least one notch 39 in each of the at least two lead terminals 30 ensuring better connectivity between the semiconductor package 10 and the PCB 3 in three dimensions, not hampering electrical conductivity. This improves the thermal stress resistance of semiconductor packages 100 and prolongs their lifetime in use over existing methods which only offer a two-dimensional stability and limiting electrical conductivity of the lead terminal of the known semiconductor package.

### LIST OF REFERENCE NUMERALS USED

- 1: solder
- 2: solder protrusion
- 3: printed circuit board, PCB
- 3a: mounting surface of PCB 3
- 10: semiconductor package
- 20: lead frame
- 30: lead terminal
- 30q: transition area boundary
- 30x: transition area
- 30y: interface between first portion part and further portion part
- 30z: free end of the lead terminal
- 31: exposed elongated portion of lead terminal
- 35: first portion part
- 36: further portion part
- 38: recess/through bore
- 39: notch
- 40: semiconductor die structure
- 50: connection elements
- 60: molding resin
- 100: semiconductor package according to the disclosure
- 300: lead terminal (according to the disclosure)
- 300-1/300-4: further designs of the lead terminal (according to the disclosure)
- 311: first surface
- 312: second surface
- 313: elongated side
- 314: other elongated side

## Claims

1. A semiconductor package comprising:
- an electrically conductive lead frame having at least two strip-like lead terminals;
- at least one semiconductor die structure mounted to the lead frame; and
- one or more connection elements electrically connecting the at least one semiconductor die structure with the at least two strip-like lead terminals;
- a molding resin encapsulating the lead frame, the at least one semiconductor die structure and the one or more connection elements, such that an elongated portion of each of the at least two lead strip-like terminals are exposed; wherein
the exposed elongated portion of each of the at least two strip-like lead terminals is formed of a first portion part positioned at the free end of the elongated portion and at least a further portion part extending from the first portion part away from the free end, with the first portion part structured - during use - to be mechanically and electrically connected to a printed circuit board and at least one elongated side edge of the further portion part is provided with at least one notch.

2. The semiconductor package according to claim 1, wherein the at least one notch is provided near a transition area between the first portion part and the further portion part.

3. The semiconductor package according to any of the preceding claims, wherein a cross-section of the at least one notch has a shape selected from but not limited to a semicircle, semi-ellipse, rectangle, square, semi-hexagonal, or triangle.

4. The semiconductor package according to any of the preceding claims, wherein a width dimension of the at least one notch is larger than a thickness dimension of the lead terminal.

5. The semiconductor package according to any of the preceding claims, wherein the width dimension of the at least one notch is smaller than 50% of the width distance between the elongated side edge to the other, opposite elongated side edge of the lead terminal.

6. The semiconductor package according to any of the preceding claims, wherein the at least one notch comprises a plurality of notches.

7. The semiconductor package according to claim 6, wherein the plurality of notches is provided on both elongated side edges of the lead terminal.

8. The semiconductor package according to any of the preceding claims, wherein the further portion part is further provided with at least one recess extending through the lead terminal.

9. A method of manufacturing the semiconductor package according to anyone or more of the claims 1-8, the method comprising the steps of:
i) preparing an electrically conductive lead frame comprising at least two lead terminals;
ii) providing at least one notch in at least one of the elongated sides of each of the lead terminals;
iii) mounting at least one semiconductor die structure on the lead frame;
iv) electrically connecting, using one or more connection elements, the at least one semiconductor die structure with the at least two lead terminals;
v) encapsulating, using a molding resin, the lead frame, the at least one semiconductor structure, and the one or more connection elements into a package exposing elongated portions of the at least two lead terminals; and
vi) trimming residual material from the elongated portions of the lead terminals, thereby forming a first portion part positioned on the free end of the elongated portion, structured to be mechanically and electrically connected to a printed circuit board during use and a further portion part provided with the at least one notch.

10. The method according to claim 9, wherein step iii) is performed prior to step ii),

11. The method according to claim 9 or 10, wherein the step i) of preparing the electrically conductive lead frame is performed by stamping, cutting or chemical etching.

12. The method according to any one of the claims 9-11, wherein the step ii) of providing the at least one notch is performed by stamping, cutting, chemical etching or milling.
